(19) **Europäisches Patentamt**

**European Patent Office**

**Office européen des brevets**

(11) **EP 0 743 749 B1**

(12) **FASCICULE DE BREVET EUROPEEN**

(45) Date de publication et mention
de la délivrance du brevet:
**02.08.2000 Bulletin 2000/31**

(51) Int Cl.⁷: **H03H 19/00**

(21) Numéro de dépôt: **96401000.3**

(22) Date de dépôt: **10.05.1996**

(54) **Procédé et dispositif de réduction de la sensibilité aux erreurs de déphasage d'un filtre passe-bande**

Verfahren und Anordnung zur Reduzierung der Empfindlichkeit eines Bandpassfilters gegen Phasenverschiebungsfehler

Method and device for reducing the sensitivity to phase errors of a band-pass filter

(84) Etats contractants désignés:
**DE GB**

(30) Priorité: **17.05.1995 FR 9505847**

(43) Date de publication de la demande:
**20.11.1996 Bulletin 1996/47**

(73) Titulaire: **FRANCE TELECOM**
**75015 Paris (FR)**

(72) Inventeurs:
• **Nilson, Christopher**
**38000 Grenoble (FR)**
• **Pache, Denis**
**38000 Grenoble (FR)**
• **Senn, Patrice**
**38000 Grenoble (FR)**

(74) Mandataire: **Casalonga, Axel**
**BUREAU D.A. CASALONGA - JOSSE**
**Morassistrasse 8**
**80469 München (DE)**

(56) Documents cités:
**US-A- 3 575 660**          **US-A- 3 744 015**
**US-A- 4 607 229**

• **ELECTRONICS LETTERS, vol. 8, no. 15, Juillet 1972, STEVENAGE GB, pages 380-382, XP002010022 G.D. CAIN :: "Hilbert-transform description of linear filtering"**
• **1994 IEEE INTERNATIONAL SYMPOSIUM ON CIRCUITS AND SYSTEMS, 30 MAI - 2 JUIN, 1994, LONDON, vol. 5, NEW YORK, USA, pages 273-276, XP002010023 ABEL ET AL. :: "Four - Quadrant CMOS/BiCMOS Multipliers Using Linear - Region MOS Transistors"**
• **IEEE Journal of Solid State Circuits, Vol. sc-1, No. 1, Sept. 1966, Pages 39-44 [RIGBY], "Integrated Selective Amplifiers Using Frequency Translation"**

**Description**

L'invention concerne les filtres analogiques passe-bande à bande latérale unique, et plus particulièrement ceux présentant une forte sélectivité à des fréquences élevées, typiquement quelques centaines de MHz.

L'invention s'applique avantageusement mais non limitativement aux téléphones mobiles qui utilisent des filtres très sélectifs.

L'utilisation d'opérateurs de filtrage standards tels que des intégrateurs ou des transconductances notamment, pour réaliser de tels filtres à fréquences élevées, se heurte à la difficulté de disposer d'opérateurs ayant des fréquences de transition, typiquement quelques GHz, supérieures à la fréquence de coupure de ces filtres. Ceci est impossible avec les technologies actuelles CMOS (transistors complémentaires à effet de champ à grille isolée (MOS)), BiCMOS (Bipolaire et CMOS) et même bipolaires.

Une solution connue et décrite par exemple dans l'article G.A.RIGBY "Integrated Selective Amplifiers Using Frequency Translation" IEEE JOURNAL OF SOLID-STATE CIRCUITS, VOL. SC-1, No 1, Septembre 1966, consiste à transposer à une fréquence plus faible le signal à filtrer ayant une fréquence f1, à partir d'un signal issu d'un oscillateur local, puis de filtrer le signal ainsi transposé avec un filtre passe-bas dont la largeur de la bande passante est égale à la moitié de la largeur de la bande passante du filtre passe-bande que l'on souhaite réaliser, puis de retransposer le signal ainsi filtré à la fréquence f1. L'homme du métier sait qu'il en résulte, après la deuxième transposition, un signal possédant outre une bande latérale à la fréquence f1, une bande latérale supplémentaire qu'il convient d'éliminer. La solution consiste alors à réaliser deux voies parallèles de traitement déphasées de 90° et d'additionner les deux signaux en sortie de ces deux voies de traitement.

Cependant, l'élimination de cette bande latérale indésirable dépend de la valeur du déphasage entre les voies. Si le rapport signal/bruit est théoriquement infini pour un déphasage de 90°, il tombe à 40 dB environ si le déphasage varie de l'ordre d'un demi-degré. Ceci est donc une limitation majeure de l'utilisation d'une telle solution pour la réalisation de tels filtres passe-bande sous forme monolithique, c'est-à-dire sous forme de circuits intégrés, pour lesquels un réglage n'est pas possible.

L'invention vise à apporter une solution à ce problème.

Un but de l'invention est de réduire l'effet de cette erreur de phase tout en utilisant des technologies standards de réalisation.

Telle que revendiquée, l'invention propose un procédé de réduction de la sensibilité aux erreurs de déphasage d'un filtre passe-bande à bande latérale unique (ou "à transpositions déphasées de signaux"). Dans ce procédé, on effectue en parallèle deux transpositions de fréquence d'un signal d'entrée à filtrer à l'aide respectivement d'un premier signal de mélange et d'un deuxième signal de mélange, ces deux signaux étant sensiblement en quadrature de phase, de façon à obtenir respectivement des premier et deuxième signaux transposés. On filtre respectivement les deux signaux transposés par deux filtres passe-bas, les fréquences des signaux de mélange et les bandes passantes des filtres passes-bas étant reliées à la fréquence du signal d'entrée et à la bande passante souhaitée pour le filtre passe-bande. Puis on effectue une transposition de fréquence du premier signal transposé et filtré à l'aide du deuxième signal de mélange et une transposition de fréquence du deuxième signal transposé et filtré à l'aide du premier signal de mélange. On effectue ensuite la différence des deux signaux ainsi obtenus afin d'obtenir le signal de sortie.

Telle que revendiquée, l'invention propose également un dispositif analogique de filtrage passe-bande, comprenant deux voies parallèles de traitement disposées entre l'entrée et la sortie du dispositif, chaque voie de traitement comportant une cellule de filtrage passe-bas disposée entre un mélangeur amont et un mélangeur aval. Le dispositif comprend également des moyens de transposition délivrant au mélangeur des deux voies deux signaux de mélange sensiblement en quadrature de phase.

Selon l'invention, les sorties des mélangeurs avals sont respectivement connectées aux deux entrées d'un soustracteur relié à la sortie du dispositif. Les moyens de transposition sont connectés aux mélangeurs de façon à délivrer un premier signal de mélange au mélangeur amont d'une première voie et au mélangeur aval de la deuxième voie, et un deuxième signal de mélange, sensiblement déphasé de 90° par rapport au premier signal de mélange, au mélangeur amont de la deuxième voie et au mélangeur aval de la première voie.

En d'autres termes, selon l'invention, on croise "la délivrance" des deux signaux de mélange aux deux voies de traitement.

Selon un mode avantageux de réalisation de l'invention, les moyens de transposition comportent un oscillateur local et deux cellules de déphasage dont les entrées respectives sont reliées à la sortie de l'oscillateur local. La sortie d'une première cellule de déphasage est reliée au mélangeur amont de la première voie et au mélangeur aval de la deuxième voie, et délivre un signal de mélange qui est déphasé par rapport au signal de sortie de l'oscillateur local. La sortie de la deuxième cellule de déphasage est reliée au mélangeur amont de la deuxième voie et au mélangeur aval de la première voie et délivre le deuxième signal de mélange, qui est déphasé de 90° par rapport au premier signal de mélange.

Par ailleurs, il est préférable que les mélangeurs comportent des transistors à effet de champ polarisés de façon à fonctionner dans leur région linéaire (région triode) de façon à pouvoir augmenter la dynamique d'entrée du signal à filtrer.

D'autres avantages et caractéristiques de l'invention apparaîtront à l'examen de la description détaillée d'un mode de réalisation, nullement limitatif, et des dessins annexés sur lesquels :

- la figure 1 est un synoptique schématique d'un filtre passe-bande à bande latérale unique de l'art antérieur,
- les figures 2 et 3 illustrent la sensibilité d'un tel filtre de l'art antérieur aux erreurs de déphasage,
- la figure 4 est un synoptique schématique d'un mode de réalisation d'un filtre passe-bande à bande latérale unique selon l'invention, et
- les figures 5 et 6 illustrent plus en détail certaines parties du filtre de la figure 4.

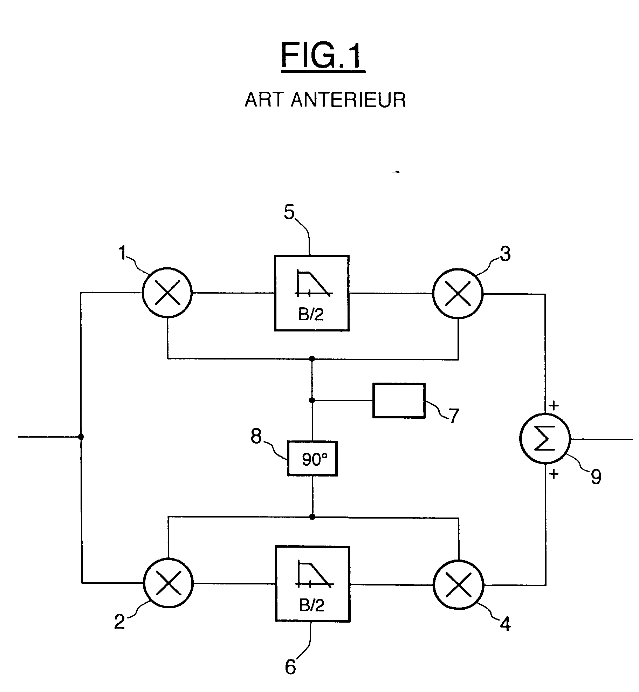

Tel qu'illustré sur la figure 1, le filtre passe-bande de l'art antérieur, dont la largeur de la bande passante est égale à B, comporte un mélangeur amont 1 suivi d'un filtre passe-bas 5 dont la largeur de la bande passante est égale à B/2. Ce filtre passe-bas 5 est suivi d'un mélangeur aval 3 dont la sortie est connectée à l'une des entrées d'un additionneur 9 reliée à la sortie du filtre.

La deuxième voie de traitement, parallèle à la première, présente une structure analogue prévoyant un filtre passe-bas 6 encadré par un mélangeur amont 2 et un mélangeur aval 4 relié à l'autre entrée de l'additionneur 9.

Un oscillateur local 7 est relié aux mélangeurs 1 et 3 de la première voie de traitement. Il est par ailleurs également relié aux mélangeurs 2 et 4 de la deuxième voie de traitement par l'intermédiaire d'une cellule de déphasage 8 produisant un déphasage de 90°.

Si l'on suppose, à des fins de simplification, que le signal de mélange délivré aux mélangeurs 1 et 3, est de la forme $\sin \omega_o t$, et que le signal de mélange délivré aux mélangeurs 2 et 4 est de la forme $\cos \omega_o t$, les signaux présents en sortie des mélangeurs 1 et 2 présentent une première bande de fréquences centrée autour de la pulsation $\omega_e - \omega_o$ (correspondant à un coefficient près à la fréquence fe-fo) et une deuxième bande de fréquences centrée autour de la pulsation $\omega_e + \omega_o$ (fréquence fe+fo), $\omega_e$ désignant la pulsation du signal d'entrée.

Pour obtenir un filtre passe-bande ayant une bande passante de largeur B il convient d'utiliser des filtres passe-bas ayant une bande passante égale à B/2. Par ailleurs la bande passante doit vérifier la relation $B > 2 |\omega_o - \omega_e|$. La limite supérieure de B dépend de la sélectivité souhaitée.

La deuxième bande des signaux est éliminée par les filtres passe-bas et, après transposition dans les mélangeurs 3 et 4, on obtient des signaux ayant une bande latérale centrée autour de la pulsation $\omega_e$ du signal d'entrée ainsi qu'une bande latérale supplémentaire indésirable centrée autour de la pulsation $2\omega_o - \omega_e$. L'élimination de cette bande latérale supplémentaire s'effectue par l'addition des deux signaux dans l'additionneur 9 pour obtenir en sortie un signal de la forme $2 \sin \omega_e t$ (on a supposé dans tout ce qui vient d'être décrit que les gains de tous les mélangeurs étaient égaux à 2).

Ceci étant, en pratique, le signal de mélange délivré aux mélangeurs 1 et 3 est de la forme $As \sin \omega_o t$, tandis que le signal de mélange délivré aux mélangeurs 2 et 4, après passage dans la cellule de déphasage 8, est de la forme $Ac \cos(\omega_o t + \varepsilon)$ où $\varepsilon$ représente l'erreur de déphasage.

Si l'on suppose que le signal d'entrée est de la forme $Ae \sin \omega_e t$, on montre alors que le signal délivré en sortie de l'additionneur 9 est de la forme :

$$Ae\,Ac^2 \left[ \frac{\sin \omega_e t}{2} + (\cos^2\varepsilon - \sin^2\varepsilon)\sin(\omega_e - 2\omega_o)t - 2\cos \varepsilon \sin \varepsilon \cos (\omega_e - 2\omega_o)t \right]$$

$$+ Ae\,As^2 \left[ \frac{\sin \omega_e t}{2} - \sin(\omega_e - 2\omega_o)t \right]$$

Cette formule se compose de termes relatifs au signal utile (pulsation $\omega_e$) et d'autres termes, que l'on qualifiera de bruit (pulsation $\omega_e - 2\omega_o$).

Le rapport en puissance signal/bruit, référencé SNR dépend alors de l'erreur de déphasage ainsi que des amplitudes de As, Ac et Ae des différents signaux.

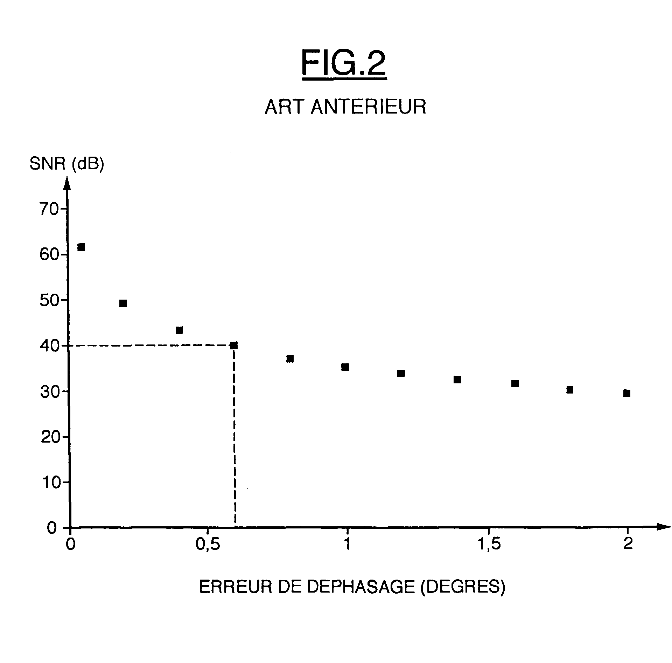

Pour une valeur de rapport d'amplitudes As/Ac donnée, on observe (figure 2) que le rapport SNR décroît lorsque l'erreur de déphasage augmente, pour tomber à 40 dB lorsque cette erreur de déphasage est proche du demi-degré.

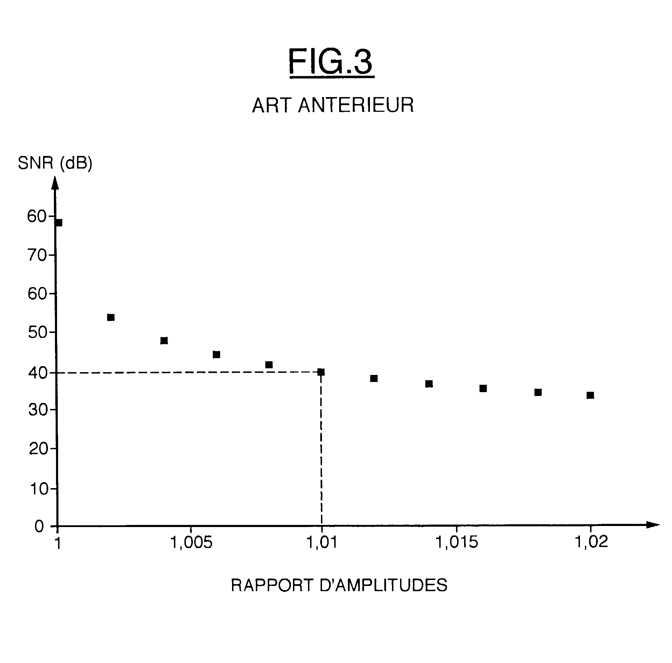

De même comme illustré sur la figure 3, et pour une erreur de déphasage donnée, ce rapport SNR décroît lorsque le rapport d'amplitudes des deux signaux de mélange augmente, pour tomber à 40 dB lorsque le rapport d'amplitudes varie de 1%.

L'invention permet de rendre ce rapporte SNR indépendant de l'erreur de déphasage, au bruit thermique près.

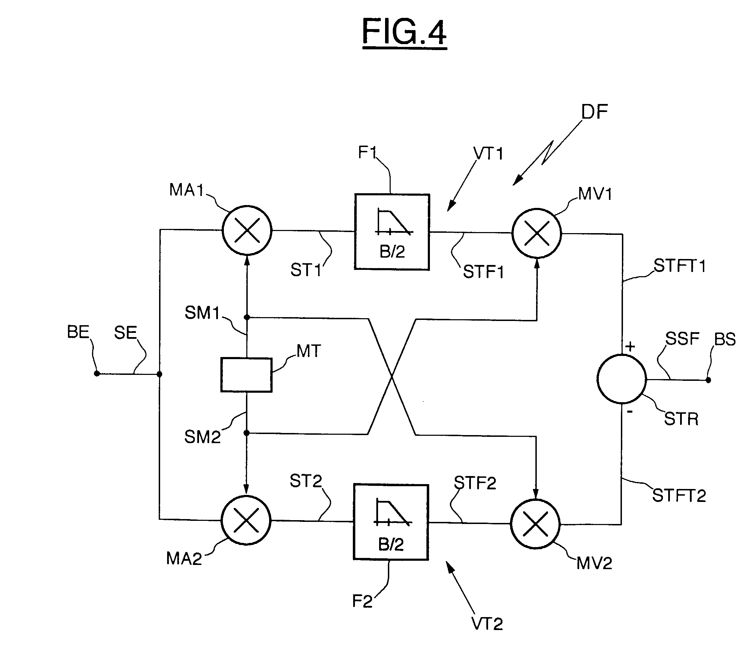

Comme illustré sur la figure 4, le filtre passe-bande DF selon l'invention comporte une borne d'entrée BE pour recevoir le signal d'entrée SE et deux voies de traitement parallèles VT1 et VT2. Chaque voie de traitement comporte un mélangeur amont MA1 (MA2) suivi d'un filtre passe-bas F1 (F2) connecté à un mélangeur aval MV1 (MV2). Les sorties respectives des mélangeurs avals sont reliées aux deux entrées d'un soustracteur STR dont la sortie est reliée à la borne de sortie BS du filtre.

Il est par ailleurs prévu des moyens de transposition MT délivrant deux signaux de mélange SM1 et SM2, théoriquement en quadratude phase, et en pratique sensiblement en quadrature de phase.

Le premier signal de mélange SM1 est délivré au mélangeur amont MA1 et le signal transposé résultant ST1 donne, après filtrage dans le filtre F1, un signal transposé filtré STF1 qui, après transposition dans le mélangeur aval MV1 à l'aide du deuxième signal de mélange SM2, fournit un signal retransposé STFT1 à l'une des entrées du soustracteur.

De même, le deuxième signal de mélange SM2 est délivré au mélangeur amont MA2 de façon à permettre l'obtention du signal transposé ST2 et, après filtrage, du signal transposé filtré STF2. Ce signal STF2 donne, après transposition dans le mélangeur aval MV2 à l'aide du premier signal de mélange SM1, le signal retransposé STFT2 délivré à l'autre entrée du soustracteur. Après différence des deux signaux STFT1 et STFT2, le signal de sortie SSF est débarrassé de la bande latérale indésirable centrée sur la pulsation $2\omega_o - \omega_e$.

Si l'on reprend les mêmes notations que celles utilisées en référence aux figures 1 à 3, on remarque alors que le signal de sortie SSF est de la forme :

$$2 \, Ae \, As \, Ac \, \cos\omega_e t \, \cos\varepsilon.$$

En d'autres termes, le signal de sortie SSF ne présente qu'un terme de signal utile et est exempt, quelle que soit l'erreur de déphasage $\varepsilon$, de tout terme de bruit lié à la bande latérale indésirable (pulsation $2\omega_o - \omega_e$).

Le rapport signal/bruit SNR est donc infini, si l'on fait abstraction du bruit thermique, et ce quelle que soit l'erreur de déphasage $\varepsilon$ et quel que soit le rapport d'amplitudes As/Ac.

En fait, l'erreur de déphasage $\varepsilon$ n'influe que sur l'amplitude du signal de sortie. A cet égard, il est donc important de pouvoir augmenter la dynamique d'entrée des signaux, c'est-à-dire de travailler avec des signaux d'entrée de grandes amplitudes. A cet égard, et bien que d'une façon générale, on puisse utiliser dans le dispositif selon l'invention, des mélangeurs classiques, par exemple à base de cellules de Gilbert, il est préférable d'utiliser des mélangeurs comportant des transistors à effet de champ fonctionnant dans leur zone linéaire (ou région triode). De tels mélangeurs offrent ainsi une distorsion plus faible ce qui permet de plus facilement augmenter la dynamique d'entrée des signaux. On pourra par exemple utiliser des mélangeurs du type de ceux décrits dans l'article de Abel et autres "Four-Quadrant CMOS/BICMOS Multipliers Using Linear-Region MOS Transistors", Proceedings, IEEE ISCAS 94, Paper S.273.

En ce qui concerne les filtres passe-bas tout mode de réalisation convient, et on peut par exemple utiliser des filtres passe-bas à base de transconductances, tels que ceux décrits dans l'article de Rolf Schaumann "Continuous-Time Integrated Filters (IEEE proceedings, Vol. 136, Pt.G, page 184-190, Août 1989.

En ce qui concerne les moyens de transposition, ceux-ci comportent d'une façon générale un oscillateur local et une cellule de déphasage de 90°.

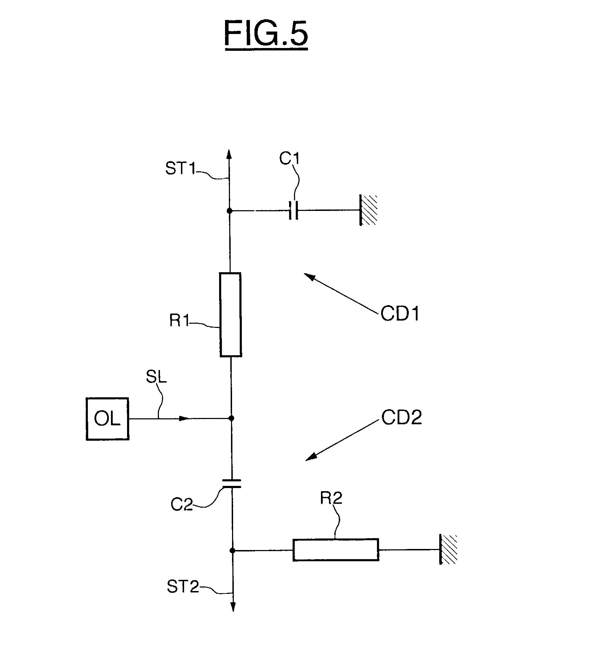

Bien qu'il soit possible de relier directement les mélangeurs MA1 et MV2 à la sortie de l'oscillateur local, et de ne disposer que d'une seule cellule de déphasage de 90° connectée entre la sortie de l'oscillateur et les mélangeurs MA2 et MV1, il s'avère préférable, notamment pour égaliser l'impédance de sortie du filtre et de rendre ce dernier moins sensible à des dispersions de valeurs dans les composants résistifs et capacitifs formant le déphaseur, de prévoir, comme illustré schématiquement sur la figure 5, deux cellules de déphasage CD1 et CD2 disposées respectivement entre la sortie de l'oscillateur local OL et les deux voies de traitement.

Plus précisément, la première cellule de déphasage CD1 est une cellule résistive capacitive comportant une résistance R1 dont une borne est connectée à la sortie de l'oscillateur et dont l'autre borne est connectée à la masse par l'intermédiaire d'une capacité C1.

L'autre cellule de déphasage CD2 est une cellule capacitive-résistive comportant une capacité C2 dont une borne est reliée à la sortie de l'oscillateur OL et dont l'autre borne est reliée à la masse par l'intermédiaire d'une résistance R2.

Après passage dans la cellule de déphasage CD1, le signal SL de sortie de l'oscillateur local subit un déphasage $-\phi$ (par exemple -45°) défini par le produit R1C1, de façon à délivrer le premier signal de mélange ST1.

La cellule de déphasage CD2, permet, puisque la résistance R2 est égale à la résistance R1 et que la capacité C2 est égale à la capacité C1, de délivrer le deuxième signal de mélange ST2 présentant un déphasage égal à 90°-φ par rapport au signal SL.

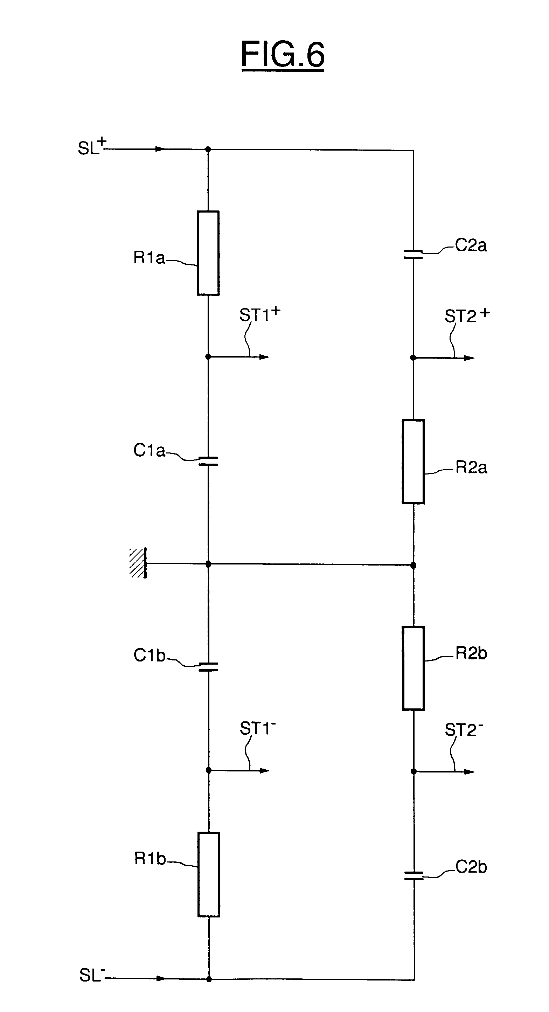

Dans tout de ce qui précède, le mode de réalisation du dispositif selon l'invention a été représenté de façon très schématique. L'homme du métier saura aisément le réaliser à partir de cette représentation. Plus particulièrement, lorsque les voies de traitement véhiculent habituellement des signaux différentiels, les entrées des mélangeurs, des filtres et du soustracteur sont en fait des paires d'entrées différentielles. Plus particulièrement, en ce qui concerne les cellules de déphasage, celles-ci sont formées en fait, comme illustré sur la figure 6, de deux résistances R1a, R1b et de deux capacités C1a et C1b, pour la cellule CD1, et de deux résistances R2a et R2b, et de deux capacités C2a et C2b pour la cellule de déphasage CD2.

## Revendications

1. Procédé de réduction de la sensibilité aux erreurs de déphasage d'un filtre passe-bande à bande latérale unique, dans lequel on effectue en parallèle deux transpositions de fréquence d'un signal d'entrée à filtrer (SE), à l'aide respectivement d'un premier signal de mélange (SM1) et d'un deuxième signal de mélange (SM2) sensiblement en quadrature de phase, de façon à obtenir respectivement des premier (ST1) et deuxième (ST2) signaux transposés, et on filtre respectivement les deux signaux transposés par deux filtres passe-bas (F1, F2), les fréquences des signaux de transposition et les bandes passantes des filtres passe-bas étant reliées à la fréquence du signal d'entrée et à la bande passante souhaitée pour le filtre passe-bande, puis on effectue une transposition de fréquence du premier signal transposé filtré (STF1) à l'aide du deuxième signal de mélange (SM2) et une transposition de fréquence du deuxième signal transposé filtré (STF2) à l'aide du premier signal de mélange (SM1), et on effectue la différence des deux signaux ainsi obtenus, de façon à obtenir le signal de sortie (SSF).

2. Dispositif analogique de filtrage passe-bande, comprenant deux voies parallèles de traitement (VT1, VT2) disposées entre l'entrée (BE) et la sortie (BS) du dispositif, comportant chacune une cellule de filtrage passe-bas (F1, F2) disposée entre un mélangeur amont (MA1, MA2) et un mélangeur aval (MV1, MV2), et des moyens de transposition (MT) délivrant aux mélangeurs des deux voies deux signaux de mélange sensiblement en quadrature de phase, caractérisé par le fait que les sorties des mélangeurs aval (MV1, MV2) sont respectivement connectées aux deux entrées d'un soustracteur (STR) relié à la sortie du dispositif, et par le fait que les moyens de transposition (MT) sont connectés aux mélangeurs de façon à délivrer un premier signal de mélange (SM1) au mélangeur amont (MA1) d'une première voie (VT1) et au mélangeur aval (MV2) de la deuxième voie (VT2), et à délivrer le deuxième signal de mélange (SM2), sensiblement déphasé de 90° par rapport au premier signal de mélange, au mélangeur amont (MA2) de la deuxième voie (VT2) et au mélangeur aval (MV1) de la première voie (VT1).

3. Dispositif selon la revendication 2, caractérisé par le fait que les moyens de transposition comportent un oscillateur local (OL) et deux cellules de déphasage (CD1, CD2) dont les entrées respectives sont reliées à la sortie de l'oscillateur local, la sortie d'une première cellule de déphasage (CD1), reliée au mélangeur amont (MA1) de la première voie et au mélangeur aval (MV2) de la deuxième voie, délivrant le premier signal de mélange (SM1) déphasé par rapport au signal de sortie (SL) de l'oscillateur local, tandis que la sortie de la deuxième cellule de déphasage (CD2), reliée au mélangeur amont (MA2) de la deuxième voie et au mélangeur aval (MV1) de la première voie, délivre le deuxième signal de mélange (SM2).

4. Dispositif selon la revendication 2 ou 3, caractérisé par le fait que les mélangeurs (MA1, MA2, MV1, MV2) comportent des transistors à effet de champ polarisés dans leur zone de fonctionnement linéaire.

## Patentansprüche

1. Verfahren zur Verringerung der Empfindlichkeit eines Bandpassfilters mit Einseitenband für Phasenverschiebungsfehler, bei dem parallel zwei Frequenzumsetzungen eines zu filternden Eingangssignals (SE) mit Hilfe eines ersten Mischsignals (SM1) bzw. eines zweiten Mischsignals (SM2), die im wesentlichen um 90° phasenverschoben sind, durchgeführt werden, um ein erstes (ST1) bzw. zweites (ST2) umgesetztes Signal zu erhalten, und bei dem die beiden umgesetzten Signale durch zwei Tiefpaßfilter (F1, F2) gefiltert werden, wobei die Frequenzen der Umsetzungssignale und die Durchlaßbereiche der Tiefpaßfilter mit der Frequenz des Eingangssignals und dem für den Bandfilter gewünschten Durchlaßbereich verbunden sind, bei dem sodann eine Frequenzumsetzung des ersten umgesetzten gefilterten Signals (STF1) mit Hilfe des zweiten Mischsignals (SM2) und eine Frequenzumsetzung des zweiten umgesetzten gefilterten Signals (STF2) mit Hilfe des ersten Mischsignals (SM1) durchgeführt wird und die Differenz der beiden auf diese Weise erhaltenen Signale erstellt wird, um das Ausgangssignal (SSF) zu erhalten.

2. Analoge Bandpassfilteranlage, umfassend zwei parallele Bearbeitungsbahnen (VT1, VT2), die zwischen dem Eingang (BE) und dem Ausgang (BS) der Anlage angeordnet sind, jeweils bestehend aus einer Tiefpaßfilterzelle (F1, F2), die zwischen einem vorlauf- bzw. eingangsseitigen Mischer (MA1, MA2) und einem nachlauf- bzw. ausgangsseitigen Mischer (MV1, MV2) angeordnet ist, und Umsetzungsmitteln (MT), die an die Mischer der beiden Bahnen zwei Mischsignale liefern, die im wesentlichen um 90° phasenverschoben sind, dadurch gekennzeichnet, daß die Ausgänge der ausgangsseitigen Mischer (MV1, MV2) jeweils an die beiden Eingänge einer Subtrahiereinrichtung (STR), die mit dem Ausgang der Anlage verbunden ist, angeschlossen sind, und dadurch, daß die Umsetzungsmittel (MT) an die Mischer angeschlossen sind, um ein erstes Mischsignal (SM1) an den eingangsseitigen Mischer (MA1) einer ersten Bahn (VT1) und an den ausgangsseitigen Mischer (MV2) der zweiten Bahn (VT2) zu liefern, und um das zweite Mischsignal (SM2), das im wesentlichen um 90° in bezug auf das erste Mischsignal phasenverschoben ist, an den eingangsseitigen Mischer (MA2) der zweiten Bahn (VT2) und an den ausgangsseitigen Mischer (MV1) der ersten Bahn (VT1) zu liefern.

3. Anlage nach Anspruch 2, dadurch gekennzeichnet, daß die Umsetzungsmittel einen lokalen Oszillator (OL) und zwei Phasenverschiebungszellen (CD1, CD2) umfassen, deren jeweilige Eingänge mit dem Ausgang des lokalen Oszillators verbunden sind, wobei der Ausgang einer ersten Phasenverschiebungszelle (CD1), die mit dem vorlaufseitigen Mischer (MA1) der ersten Bahn und dem nachlaufseitigen Mischer (MV2) der zweiten Bahn verbunden ist, das erste Mischsignal (SM1) liefert, das in bezug auf das Ausgangssignal (SL) des lokalen Oszillators phasenverschoben ist, während der Ausgang der zweiten Phasenverschiebungszelle (CD2), die mit dem eingangsseitigen Mischer (MA2) der zweiten Bahn und dem ausgangsseitigen Mischer (MV1) der ersten Bahn verbunden ist, das Mischsignal (SM2) liefert.

4. Anlage nach Anspruch 2 oder 3, dadurch gekennzeichnet, daß die Mischer (MA1, MA2, MV1, MV2) Feldeffekttransistoren umfassen, die in ihrem linearen Funktionsbereich polarisiert sind.

## Claims

1. Method of reducing the sensitivity to phase-shift errors of a single-sideband bandpass filter, in which two frequency transpositions of an input signal to be filtered (SE) are carried out in parallel, using respectively a first mixing signal (SM1) and a second mixing signal (SM2) substantially in phase quadrature, so as to obtain respectively first (ST1) and second (ST2) transposed signals, and the two transposed signals are filtered respectively by two low-pass filters (F1, F2), the frequencies of the transposition signals and the passbands of the low-pass filters being related to the frequency of the input signal and to the passband desired for the bandpass filter, then a frequency transposition of the first filtered transposed signal (STF1) is carried out using the second mixing signal (SM2) and a frequency transposition of the second filtered transposed signal (STF2) is carried out using the first mixing signal (SM1), and the difference of the two signals thus obtained is formed, so as to obtain the output signal (SSF).

2. Analog bandpass filtering device, comprising two parallel processing channels (VT1, VT2) arranged between the input (BE) and the output (BS) of the device, each including a low-pass filtering cell (F1, F2) arranged between an upstream mixer (MA1, MA2) and a downstream mixer (MV1, MV2), and transposition means (MT) delivering, to the mixers of the two channels, two mixing signals which are substantially in phase quadrature, characterized in that the outputs of the downstream mixers (MV1, MV2) are connected respectively to the two inputs of a subtracter (STR) which is linked to the output of the device, and in that the transposition means (MT) are connected to the mixers so as to deliver a first mixing signal (SM1) to the upstream mixer (MA1) of a first channel (VT1) and to the downstream mixer (MV2) of the second channel (VT2), and to deliver the second mixing signal (SM2), phase shifted by substantially 90° with respect to the first mixing signal, to the upstream mixer (MA2) of the second channel (VT2) and to the downstream mixer (MV1) of the first channel (VT1).

3. Device according to Claim 2, characterized in that the transposition means include a local oscillator (OL) and two phase-shifting cells (CD1, CD2) the respective inputs of which are linked to the output of the local oscillator, the output of a first phase-shifting cell (CD1), linked to the upstream mixer (MA1) of the first channel and to the downstream mixer (MV2) of the second channel, delivering the first mixing signal (SM1) phase shifted with respect to the output signal (SL) of the local oscillator, while the output of the second phase-shifting cell (CD2), linked to the upstream mixer (MA2) of the second channel and to the downstream mixer (MV1) of the first channel, delivers the second mixing signal (SM2).

4. Device according to Claim 2 or 3, characterized in that the mixers (MA1, MA2, MV1, MV2) include field-effect transistors biased into their linear operating region.

# FIG.1

## ART ANTERIEUR

# FIG.2

## ART ANTERIEUR

# FIG.3

ART ANTERIEUR

# FIG.4

# FIG.5

# FIG.6